# EUROPÄISCHE PATENTSCHRIFT

(11) **EP 0 525 295 B1**
(45) Veröffentlichungstag und Bekanntmachung des Hinweises auf die Patenterteilung: **22.05.1996**
(21) Anmeldenummer: 92104950.8
(22) Anmeldetag: 21.03.1992
(51) Int. Cl.: H01J 37/34, C23C 14/34

(54) **Magnetron-Zerstäubungskathode für Vakuumbeschichtungsanlagen**
Cathode for magnetron sputtering for vacuum deposition apparatus
Cathode de pulvérisation magnétron pour dispositif de dépôt sous vide

(30) Priorität: 30.07.1991 DE 4125110
(43) Veröffentlichungstag der Anmeldung: 03.02.1993
(73) Patentinhaber: LEYBOLD AKTIENGESELLSCHAFT, D-63450 Hanau (DE)
(72) Erfinder: Maass, Wolfram, Dr., W-6455 Erlensee (DE)

(56) Entgegenhaltungen:
- EP-A- 0 248 244
- EP-A- 0 337 012
- EP-A- 0 399 710
- PATENT ABSTRACTS OF JAPAN vol. 8, no. 150 (C-233)(1587) 12. Juli 1984 ; & JP-A-59 56 580
- PATENT ABSTRACTS OF JAPAN vol. 14, no. 568 (E-1014) 18. Dezember 1990 ; & JP-A-02 246 216

## Beschreibung

Die Erfindung betrifft eine Magnetron-Zerstäubungskathode für Vakkumbeschichtungsanlagen mit einer kreisscheibenförmigen Targetplatte aus dem zu zerstäubenden Material und mit hinter der Targetplatte auf Jochplatten angeordneten Magnetanordnungen, umfassend mindestens eine in sich geschlossene Reihe von auf einem Kreisbogen angeordneten Permanentmagneten und eine zweite, innerhalb der ersten Magnetanordnung exzentrisch und radial nach innen zu versetzte Magnetanordnung entgegengesetzter Pollage, die mit der ersten Magnetanordnung einen ungleichförmig geschlossenen magnetischen Tunnel bildet, wobei die zweite Magnetanordnung auf einer kreisringförmigen Jochplatte vorgesehen ist, die motorisch angetrieben um die Mittenachse der Zerstäubungskathode drehbar ist.
Magnetron-Zerstäubungskathoden zeichnen sich durch eine um den Faktor 10 bis 30 höhere Zerstäubungsrate gegenüber Zerstäubungssystemen ohne Magnetfeldunterstützung aus. Dieser Vorteil wird jedoch mit dem Nachteil einer äußerst ungleichförmigen Zerstäubung der Targetplatte erkauft, denn die bei Magnetrons durch den magnetischen Tunnel erzwungene Einschnürung des Plasmas äußert sich in einer entsprechenden räumlichen Begrenzung des Zerstäubungseffekts. Durch Ausbildung eines tiefen Erosionsgrabens, dessen tiefste Stelle unter den Kulminationspunkten der magnetischen Feldlinien liegt, muß der Zerstäubungsvorgang beendet werden, nachdem nur etwa 25 bis 30 % des Targetmaterials zerstäubt sind.

Bei stationären Beschichtungssystemen, d. h. bei solchen ohne Relativbewegung zwischen Kathode und den Substraten, hat dies sehr ungleichmäßige Schichtdikkenverteilungen zur Folge. Im Prinzip würde der Erosionsgraben quasi fotografisch auf den Substraten gebildet.

Diese Problematik sowie eine Reihe von Lösungsversuchen werden in der DE-OS 27 07 144 angesprochen. Zu den Lösungsversuchen gehört auch eine Magnetron-Zerstäubungskathode der eingangs angegebenen Gattung, bei der jeweils ein einziges in sich geschlossenes Magnetsystem in exzentrischer Lage hinter einer kreisförmigen Targetplatte rotiert (Figuren 22 bis 25).

Abgesehen davon, daß hierbei nur ein winziger Teil der Targetoberfläche gleichzeitig der Zerstäubung ausgesetzt wird (womit ein Teil des Magnetron-Effekts wieder zunichte gemacht wird), ist die Zerstäubungsrate auf der Targetoberfläche auch sehr ungleichmäßig, weil einmal die Verweilzeiten unter dem rotierenden magnetischen Tunnel ungleichmäßig sind und weil zum anderen das Produkt aus der Intensität des Plasmas, der sogenannten Plasmadichte, und der Verweilzeit in radialer Richtung unterschiedlich sind. Eine ungleichförmige Zerstäubungsrate führt aber nicht nur zu einer ungleichförmigen Abtragung des Targetmaterials, sondern auch zu einer ungleichförmigen Niederschlagsrate auf den der Targetoberfläche gegenüberliegenden und zu beschichtenden Substraten.

Weiterhin ist eine Magnetron-Zerstäubungskathode für Vakuumbeschichtungsanlagen bekannt (DE-A-36 19 194), mit einer kreisförmigen Targetplatte aus dem zu zerstäubenden Material und mit mindestens einem hinter der Targetplatte angeordneten Magnetsystem, das aus jeweils zwei ineinanderliegenden, in sich geschlossenen Reihen von Permanentmagneten besteht, wobei die Magnete einer jeden Reihe die gleiche Pollage, die Magnete beider Reihen aber zueinander eine entgegengesetzte Pollage aufweisen, derart, daß über der Targetplatte mindestens ein in sich geschlossener Tunnel aus von der einen Magnetreihe ausgehenden und zur anderen Magnetreihe zurückkehrenden magnetischen Feldlinien gebildet wird, und mit einer Antriebseinrichtung für die kontinuierliche Drehung des Magnetsystems um die Mittenachse der Targetplatte, wobei im Randbereich der Targetplatte ein erstes Magnetsystem für die Erzeugung eines ersten, zur Drehachse im wesentlichen konzentrischen magnetischen Tunnels angeordnet ist und wobei zwischen der Drehachse und dem ersten Magnetsystem ein exzentrisch versetztes zweites Magnetsystem angeordnet ist, das sich nur über einen Sektor der Targetplatte erstreckt, derart, daß bei einer gemeinsamen Drehung beider Magnetsysteme die Flächenelemente der Targetplatte dem Produkt aus Verweilzeit und Intensität dergestalt ausgesetzt sind, daß die Targetplatte im mittleren Bereich gleichmäßiger und am Rande stärker abgetragen wird, so daß ein gegenüber der Targetplatte angebrachtes Substratfeld beschichtet wird.

Schließlich ist eine Magnetron-Zerstäubungskathode (JP-A-59-056580) für Vakuumbeschichtungsanlagen bekannt, mit einer im wesentlichen konzentrisch zur Drehachse angeordneten ersten Magnetreihe und einer zweiten, aus einem einzigen Magneten gebildeten Magnetanordnung, die zwischen den Drehachsen und der ersten Magnetreihe exzentrisch angeordnet ist, wobei die zweite Magnetanordnung gegenüber der ersten gedreht wird. Nachteilig bei dieser Magnetron-Zerstäubungskathode ist die noch immer ungenügende Schichtdickenverteilung.

Der Erfindung liegt daher die Aufgabe zugrunde, bei einer Magnetron-Zerstäubungskathode des vorstehend genannten Typs die Schichtdickenverteilung auf den zu beschichtenden Substraten gegenüber den herkömmlichen Kathoden weiter zu verbessern.

Die Lösung der gestellten Aufgabe erfolgt erfindungsgemäß dadurch, daß der von einer geschlossenen Reihe von Magneten umschlossenen zweiten Magnetanordnung eine dritte Gruppe von Permanentmagneten im radial äußeren Bereich der die zweite Magnetanordnung tragenden kreisförmigen Jochplatte (9,20) zugeordnet ist, deren Magnete sich in einer Reihe über ein Teilstück eines Kreisbogens erstrecken und deren Pollage derjenigen der ersten Magnetanordnung entspricht, wobei eine zentrale vierte Magnetanordnung, deren Pollage derjenigen der zweiten Magnetanordnung entspricht, drehfest angeordnet ist und von der rotierenden kreisförmigen Jochplatte umschlossen ist derart, daß bei einer Drehung der zweiten Magnetanordnung um die Drehachse die Flächenelemente der Targetplatte dem Produkt der Verweilzeit und Intensität dergestalt ausgesetzt sind, daß die Targetplatte gleichmäßig und am Rande stärker abgetragen wird, so daß ein gegenüber der Targetplatte angebrachtes Substratfeld gleichförmig beschichtet wird.

Durch die Merkmale nach der Erfindung wird sichergestellt, daß die ansonsten im Randbereich des Substratfeldes zu beobachtende Verminderung der Niederschlagsrate kompensiert wird und auch der innerhalb des Randbereichs liegende Bereich des Substratfeldes gleichmäßig beschichtet wird, wobei man es durch die Gestaltung der Ausdehnung der Magnetgruppe und des Verlaufs des magnetischen Tunnels in diesem Sektor in der Hand hat, eine außerordentlich gleichmäßige Beschichtung über das gesamte Substratfeld herbeizuführen.

Eine Optimierung des Systems kann durch Verschieben oder Verändern der auf der Jochplatte angeordneten Magnete erfolgen, wenn der Fachmann Abweichungen von der idealen Schichtdickenverteilung beobachten sollte.
Es hat sich in praktischen Versuchen herausgestellt, daß durch die Verknüpfung der erfindungsgemäßen Merkmale auf den Substraten bis in den Randbereich des Substratfeldes eine sehr gleichmäßige Schichtdickenverteilung und Schichtqualität erzielt werden konnte.

Weitere Einzelheiten und Merkmale der Erfindung sind in den Patentansprüchen näher beschrieben und gekennzeichnet.

Zwei Ausführungsbeispiele des Erfindungsgegenstandes werden nachstehend anhand der Figuren 1 bis 3 näher erläutert.

Es zeigen:
- Figur 1: die Draufsicht auf eine Magnetron-Zerstäubungskathode, bei der eine kreisscheibenförmige Halterung für zwei radial innenliegende Magnetgruppen und ein zentraler, feststehender Mittelmagnet vorgesehen sind,
- Figur 2: einen Axialschnitt durch die Zerstäubungskathode nach Figur 1 und
- Figur 3: einen Axialschnitt durch eine Doppelringkathode mit einem höhenverstellbaren Mittelmagneten und einer kreisringförmigen Halterung für Magnetgruppen, die gegenüber radial außenliegenden Magnetreihen drehbar sind.

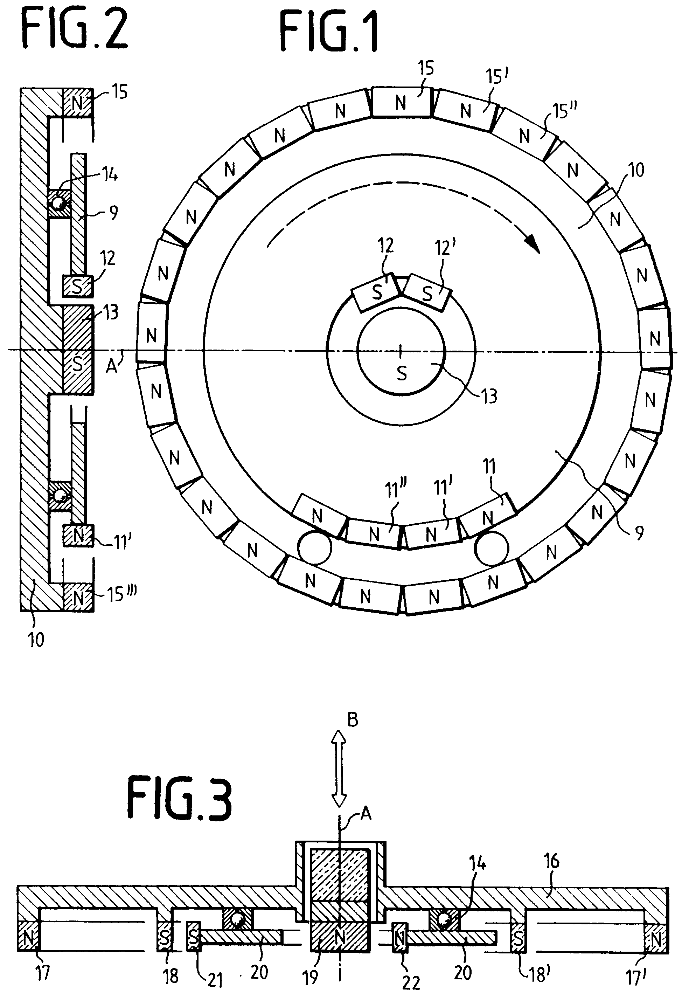

Bei dem Ausführungsbeispiel nach den Figuren 1 und 2 ist unterhalb der kreisscheibenförmigen Jochplatte 10 eine kreisringförmige Jochplatte 9 so angeordnet, daß diese Platte 9 um die konzentrische Achse A rotieren kann, wobei sowohl im radial äußeren Randbereich als auch im radial inneren Randbereich der Jochplatte 9 jeweils eine Gruppe von Permanentmagneten 11, 11', ... bzw. 12, 12', ... unterschiedlicher Polung fest angeordnet sind (zweite und dritte Magnetanordnung).

Schließlich ist die kreisscheibenförmige Jochplatte 10 in ihrem Zentrum noch mit einem kreiszylinderabschnittsförmigen Permanentmagneten 13 (vierte Magnetanordnung) und an ihrem radial äußeren Randbereich noch mit einer Reihe von Permanentmagneten 15, 15', ... (erste Magnetanordnung) versehen. Die kreisringförmige Jochplatte 9 weist außerdem ein Kugellager 14 auf, das die Rotation der Jochplatte 9 ermöglicht.

Gegenüber einem herkömmlichen rotationssymmetrischen System sind also bei der Kathode nach den Figuren 1 und 2 zusätzliche Magnete 11, 11', ... bzw. 12, 12', ... auf einer rotierenden Scheibe 9 angebracht, wodurch zusätzliche Magnetfelder erzeugt werden, die ein zyklisches Verschieben der Magnetfelder bewirken und die Ausbildung von Rücksputterzonen verhindern.

Das Ausführungsbeispiel nach Figur 3 unterscheidet sich von demjenigen nach den Figuren 1 und 2 im wesentlichen dadurch, daß auf der Jochplatte 16 auf ihrem radial äußeren Randbereich zwei konzentrische, geschlossene Reihen von Permanentmagneten 17, 17', ... bzw. 18, 18', ... vorgesehen sind, daß die Jochplatte 16 kreisringförmig ausgebildet ist und daß der zentrale Magnet 19 in Längsrichtung der Rotationsachse B verschiebbar gehalten und geführt ist.

Im übrigen ist die Jochplatte 20 vorgesehen, die als Kreisringscheibe ausgebildet ist und die sowohl an ihrem radial inneren Bereich als auch an ihrem radial äußeren Bereich mit Magneten 21 bzw. 22 bestückt ist.

Gemäß der vorliegenden Beschreibung besteht also das Jochsystem im wesentlichen aus zwei konzentrischen Teilen, wobei das äußere Teil mit dem Targethaltetopf (nicht dargestellt) verbunden ist und das innere Teil mit entsprechender Magnetbestückung rotiert. Die dadurch erzeugten zusätzlichen Magnetfelder bewirken ein zyklisches Verschieben der originalen Felder und verhindern die Ausbildung von Rücksputterzonen, so daß von einem "Plasma-Vibrationsmagnetron" gesprochen werden kann (da aufgrund der Rotation eines Teils des Jochs und eines Teils der Magnetanordnungen tatsächlich der Plasmaring bzw. die Plasmaringe in eine Art vibrierende Bewegung versetzt werden).

Es ist klar, daß anstelle einer gleichmäßigen Rotation des inneren Teils auch eine ungleichförmige - z. B. ein ruckartig beschleunigte oder ruckartig verzögerte - Bewegung vorgesehen werden kann. Ebenso kann eine Drehbewegung bei variierenden Drehzahlen bewirkt werden.

### Bezugszeichenliste

- 9: kreisringförmige Jochplatte
- 10: kreisscheibenförmige Jochplatte
- 11, 11', ...: Permanentmagnet
- 12, 12', ...: Permanentmagnet
- 13: Permanentmagnet, kreiszylinderabschnittförmiger Magnet
- 14: Kugellager
- 15, 15', ...: Permanentmagnet
- 16: Jochplatte
- 17, 17', ...: Permanentmagnet
- 18, 18', ...: Permanentmagnet
- 19: zentraler Magnet, kreiszylinderabschnittförmiger Magnet
- 20: Jochplatte
- 21: Permanentmagnet
- 22: Permanentmagnet

## Patentansprüche

1. Magnetron-Zerstäubungskathode für Vakkumbeschichtungsanlagen mit einer kreisscheibenförmigen Targetplatte aus dem zu zerstäubenden Material und mit hinter der Targetplatte auf Jochplatten (9, 10, 16,) angeordneten Magnetanordnungen, umfassend mindestens eine in sich geschlossene Reihe von auf einem Kreisbogen angeordneten Permanentmagneten (15,15',...,18,18',...)und eine zweite, innerhalb der ersten Magnetanordnung exzentrisch und radial nach Innen zu versetzte Magnetanordnung (12,12',22) entgegengesetzter Pollage, die mit der ersten Magnetanordnung einen ungleichförmig geschlossenen magnetischen Tunnel bildet, wobei die zweite Magnetanordnung auf einer kreisringförmigen Jochplatte (9,20) vorgesehen ist, die motorisch angetrieben um die Mittenachse (A) der Zerstäubungskathode drehbar ist, **dadurch gekennzeichnet**, daß der von einer geschlossenen Reihe von Magneten umschlossenen zweiten Magnetanordnung (12,12',22) eine dritte Gruppe von Permanentmagneten (11,11',...,21) im radial äußeren Bereich der die zweite Magnetanordnung (12,12',22) tragenden kreisförmigen Jochplatte (9,20) zugeordnet ist, deren Magnete (11,11',...;21) sich in einer Reihe über ein Teilstück eines Kreisbogens erstrecken und deren Pollage derjenigen der ersten Magnetanordnung (15, 15',...;18, 18') entspricht, wobei eine zentrale vierte Magnetanordnung (13;19), deren Pollage derjenigen der zweiten Magnetanordnung entspricht, drehfest angeordnet ist und von der rotierenden kreisförmigen Jochplatte (9,20) umschlossen ist, derart, daß bei einer Drehung der zweiten Magnetanordnung (12,12';22) um die Drehachse (A) die Flächenelemente der Targetplatte dem Produkt der Verweilzeit und Intensität dergestalt ausgesetzt sind, daß die Targetplatte gleichmäßig und am Rande stärker abgetragen wird, so daß ein gegenüber der Targetplatte angebrachtes Substratfeld gleichförmig beschichtet wird.

2. Magnetron-Zerstäubungskathode nach Anspruch 1, **dadurch gekennzeichnet**, daß die Gruppe von Permanentmagneten (11,11',...;21) der dritten Magnetanordnung am radial äußeren Randbereich der kreisförmigen Jochplatte (9;20) und die Gruppe von radial innenliegenden Permanentmagneten (12,12';22) der zweiten Magnetanordnung am radial inneren Randbereich dieser Jochplatte (9;20) gehalten sind, wobei die Jochplatte (9;20) um einen drehfest vorgesehenen, kreiszylindrischen Mittelmagneten (13;19) als vierte Magnetanordnung rotiert.

3. Magnetron-Zerstäubungskathode nach den Ansprüchen 1 und 2, **dadurch gekennzeichnet**, daß die von der kreisförmigen, rotierenden Jochplatte (20) umschlossene, drehfeste zentrale Magnetanordnung (19) in Richtung der Rotationsachse (B) verschiebbar ist.

## Claims

1. A magnetron sputtering cathode for vacuum coating apparatus with a circular-disc-shaped target plate composed of the material to be sputtered and with magnet arrangements disposed behind the target plate on yoke plates (9, 10, 16), comprising at least one self-enclosed row of permanent magnets (15, 15', ..., 18, 18',...) arranged on a circular arc and a second magnet arrangement (12, 12', 22) with an opposing pole position which is offset eccentrically and radially inwards within the first magnet arrangement and, with the first magnet arrangement, forms a non-uniformly closed magnetic tunnel, where the second magnet arrangement is disposed on a circular-ring-shaped yoke plate (9, 20) which, driven by a motor, is rotatable about the central axis (A) of the sputtering cathode, characterised in that the second magnet arrangement (12, 12', 22), which is surrounded by a closed row of magnets, is assigned a third group of permanent magnets (11, 11', ..., 21) in the radially outer zone of the circular yoke plate (9, 20) which bears the second magnet arrangement (12, 12', 22), where the magnets (11, 11', ...; 21) of said third group extend in a row over a portion of a circular arc and the pole position of said third group corresponds to that of the first magnet arrangement (15, 15', ...; 18, 18'), where a central fourth magnet arrangement (13; 19), the pole position of which corresponds to that of the second magnet arrangement, is disposed so as to be rotation-resistant and is surrounded by the rotating circular yoke plate (9, 20) in such manner that when the second magnet arrangement (12, 12'; 22) rotates about the axis of rotation (A), the surface elements of the target plate are exposed to the product of the dwell time and intensity in such a way that the target plate is uniformly eroded and to a greater extent at the edge so that a substrate field arranged opposite the target plate is uniformly coated.

2. A magnetron sputtering cathode as claimed in Claim 1, characterised in that the group of permanent magnets (11, 11', ...; 21) of the third magnet arrangement is retained at the radially outer edge zone of the circular yoke plate (9; 20) and the group of radially inner permanent magnets (12, 12'; 22) of the second magnet arrangement is retained at the radially inner edge zone of this yoke plate (9; 20), where the yoke plate (9; 20) rotates about a circular-cylindrical central magnet (13; 19), arranged so as to be rotation-resistant, as fourth magnet arrangement.

3. A magnetron sputtering cathode as claimed in Claims 1 and 2, characterised in that the rotation-resistant, central magnet arrangement (19), which is surrounded by the circular, rotating yoke plate (20), is displaceable in the direction of the axis of rotation (B).

## Revendications

1. Cathode de pulvérisation à magnétron pour des dispositifs de revêtement sous vide, comportant une plaquette cible. en forme de disque circulaire, en le matériau à pulvériser et comportant des agencements d'aimants qui sont disposés derrière la plaquette cible, sur des plaques de culasse (9, 10, 16) comprenant au moins une rangée, fermée en soi, d'aimants permanents (15,15',...,18,18',...) disposés sur un arc de cercle et un second agencement d'aimants (12,12',22), de position de pôles opposée, qui est à l'intérieur du premier agencement d'aimants, qui est décalée excentriquement et radialement vers l'intérieur et qui forme avec le premier agencement d'aimants un tunnel magnétique fermé de forme non uniforme, étant précisé que le second agencement d'aimants est prévu sur une plaque de culasse (9,20), en forme d'anneau circulaire, qui, entraînée par un moteur, peut être entraînée en rotation autour de l'axe médian (A) de la cathode de pulvérisation, caractérisée par le fait qu'au second agencement d'aimants (12,12',22), entouré par une rangée fermée d'aimants, est associé, dans la zone radialement extérieure de la plaque de culasse (9,20) de forme circulaire portant le second agencement d'aimants (12,12',22), un troisième groupe d'aimants permanents (11,11',...,21) dont les aimants (11,11'...;21) s'étendent en une rangée sur une partie d'un arc de cercle et dont la position des pôles correspond à celle du premier agencement d'aimants (15,15',...;18,18'), étant précisé qu'un quatrième agencement d'aimants (13;19), central, dont la position des pôles correspond à celle du second agencement d'aimants, est disposé fixe en rotation et est entouré par la plaque de culasse circulaire rotative (9,20), de façon telle que, lors d'une rotation du second agencement d'aimants (12,12;22) autour de l'axe de rotation (A), les éléments de surface de la plaquette cible sont exposés au produit du temps de séjour et de l'intensité de façon telle que la plaquette cible est attaquée régulièrement et plus fortement en bordure de sorte qu'une zone du substrat placée en face de la plaquette cible est revêtue uniformément.

2. Cathode de pulvérisation à magnétron selon la revendication 1, caractérisée par le fait que le groupe d'aimants permanents (11,11',...;21) du troisième agencement d'aimants est maintenu sur la zone de bordure radialement extérieure de la plaque de culasse circulaire (9;20) et que le groupe d'aimants permanents (12,12';22), situés radialement à l'intérieur, du second agencement d'aimants est maintenu sur la zone de bordure radialement intérieure de cette plaque de culasse (9;20), étant précisé que la plaque de culasse (9,20) est entraînée en rotation autour d'un aimant médian (13;19), en forme de cylindre circulaire, prévu fixe en rotation et servant de quatrième agencement d'aimant.

3. Cathode de pulvérisation à magnétron selon les revendications 1 et 2, caractérisée par le fait que l'agencement d'aimant central (19), fixe en rotation, entouré par la plaque de culasse rotative (20) de forme circulaire, peut coulisser selon la direction de l'axe de rotation (B).
